# EUROPEAN PATENT APPLICATION

(11) **EP 4 727 323 A1**
(43) Date of publication of application: **15.04.2026**
(21) Application number: 23940708.3
(22) Date of filing: 08.06.2023
(51) Int. Cl.: H10N 60/12, H10N 60/01

(54) **ELECTRONIC DEVICE AND METHOD FOR MANUFACTURING ELECTRONIC DEVICE**

(71) Applicant: FUJITSU LIMITED, Kawasaki-shi, Kanagawa 211-8588 (JP)
(72) Inventor: TAKAHASHI, Tsuyoshi, Kawasaki-shi, Kanagawa 211-8588 (JP)
(74) Representative: Haseltine Lake Kempner LLP
(86) International application number: PCT/JP2023/021317
(87) International publication number: WO 2024/252608

(57) **Abstract**

An electronic device includes a substrate having a recessed portion on a first surface; a first superconducting wiring having a portion in contact with the first surface; a second superconducting wiring intersecting the first superconducting wiring in a plan view above the recessed portion and having a portion in contact with the first surface; an insulating film provided between the first superconducting wiring and the second superconducting wiring; and a first support member provided in the recessed portion and supporting at least one of the first superconducting wiring or the second superconducting wiring, wherein a hollow portion is formed between a region where the first superconducting wiring and the second superconducting wiring intersect in a plan view and a bottom surface of the recessed portion.

## Description

### TECHNICAL FIELD

The present disclosure relates to an electronic device and method of manufacturing the electronic device.

### BACKGROUND ART

An electronic device having a quantum bit including a Josephson junction element may be used in a quantum computer. In a conventional electronic device, the Josephson junction element is formed on a substrate such as a silicon substrate.

### CITATION LIST

### PATENT DOCUMENT

Patent Document 1: Japanese Translation of PCT International Application Publication No. JP-T-2020-503690
Patent Document 2: Japanese Translation of PCT International Application Publication No. JP-T-2022-528146
Patent Document 3: Japanese Translation of PCT International Application Publication No. JP-T-2020-535461

### SUMMARY OF INVENTION

### TECHNICAL PROBLEM

In order to improve the fidelity of a quantum computer, a longer coherence time is required for a quantum bit including a Josephson junction element. However, in a conventional electronic device, a Josephson junction element is susceptible to a defect referred to as a two level system (TLS) existing in a substrate, and it is difficult to extend the coherence time.

An object of the present disclosure is to provide an electronic device capable of reducing the influence of a two-level system, and a method of manufacturing the electronic device.

### SOLUTION TO PROBLEM

According to one aspect of the present disclosure, there is provided an electronic device including a substrate having a recessed portion on a first surface; a first superconducting wiring having a portion in contact with the first surface; a second superconducting wiring intersecting the first superconducting wiring in a plan view above the recessed portion and having a portion in contact with the first surface; an insulating film provided between the first superconducting wiring and the second superconducting wiring; and a first support member provided in the recessed portion and supporting at least one of the first superconducting wiring or the second superconducting wiring, wherein a hollow portion is formed between a region where the first superconducting wiring and the second superconducting wiring intersect in a plan view and a bottom surface of the recessed portion.

### ADVANTAGEOUS EFFECTS OF INVENTION

According to the present disclosure, the influence of the two-level system can be reduced.

### BRIEF DESCRIPTION OF THE DRAWINGS

[FIG. 1] FIG. 1 is a perspective view illustrating an electronic device according to a first embodiment.
[FIG. 2] FIG. 2 is a cross-sectional view (no. 1) illustrating an electronic device according to a first embodiment.
[FIG. 3] FIG. 3 is a cross-sectional view (no. 2) illustrating an electronic device according to a first embodiment.
[FIG. 4] FIG. 4 is a plan view (no. 1) illustrating a method of manufacturing an electronic device according to a first embodiment.
[FIG. 5] FIG. 5 is a plan view (no. 2) illustrating a method of manufacturing an electronic device according to a first embodiment.
[FIG. 6] FIG. 6 is a plan view (no. 3) illustrating a method of manufacturing an electronic device according to a first embodiment.
[FIG. 7] FIG. 7 is a plan view (no. 4) illustrating a method of manufacturing an electronic device according to a first embodiment.
[FIG. 8] FIG. 8 is a plan view (no. 5) illustrating a method of manufacturing an electronic device according to a first embodiment.
[FIG. 9] FIG. 9 is a plan view (no. 6) illustrating a method of manufacturing an electronic device according to a first embodiment.
[FIG. 10] FIG. 10 is a plan view (no. 7) illustrating a method of manufacturing an electronic device according to the first embodiment.
[FIG. 11] FIG. 11 is a plan view (no. 8) illustrating a method of manufacturing an electronic device according to the first embodiment.
[FIG. 12] FIG. 12 is a plan view (no. 9) illustrating a method of manufacturing an electronic device according to the first embodiment.
[FIG. 13] FIG. 13 is a plan view (no. 10) illustrating a method of manufacturing an electronic device according to the first embodiment.
[FIG. 14] FIG. 14 is a plan view (no. 11) illustrating a method of manufacturing an electronic device according to the first embodiment.
[FIG. 15] FIG. 15 is a cross-sectional view (no. 1) illustrating a method of manufacturing an electronic device according to the first embodiment.
[FIG. 16] FIG. 16 is a cross-sectional view (no. 2) illustrating a method of manufacturing an electronic device according to the first embodiment.
[FIG. 17] FIG. 17 is a cross-sectional view (no. 3) illustrating a method of manufacturing an electronic device according to the first embodiment.
[FIG. 18] FIG. 18 is a cross-sectional view (no. 4) illustrating a method of manufacturing an electronic device according to the first embodiment.
[FIG. 19] FIG. 19 is a cross-sectional view (no. 5) illustrating a method of manufacturing an electronic device according to the first embodiment.
[FIG. 20] FIG. 20 is a cross-sectional view (no. 6) illustrating a method of manufacturing an electronic device according to the first embodiment.
[FIG. 21] FIG. 21 is a cross-sectional view (no. 7) illustrating a method of manufacturing an electronic device according to the first embodiment.
[FIG. 22] FIG. 22 is a cross-sectional view (no. 8) illustrating a method of manufacturing an electronic device according to the first embodiment.
[FIG. 23] FIG. 23 is a cross-sectional view (no. 9) illustrating a method of manufacturing an electronic device according to the first embodiment.
[FIG. 24] FIG. 24 is a cross-sectional view (no. 10) illustrating a method of manufacturing an electronic device according to the first embodiment.
[FIG. 25] FIG. 25 is a cross-sectional view (no. 11) illustrating a method of manufacturing an electronic device according to the first embodiment.
[FIG. 26] FIG. 26 is a perspective view illustrating an electronic device according to the second embodiment.
[FIG. 27] FIG. 27 is a perspective view illustrating an electronic device according to the third embodiment.
[FIG. 28] FIG. 28 is a diagram illustrating a quantum computing device according to the fourth embodiment.

### DESCRIPTION OF EMBODIMENTS

Hereinafter, embodiments of the present disclosure will be specifically described with reference to the accompanying drawings. In the present specification and the drawings, components having substantially the same functional configuration may be given the same reference numerals, thereby eliminating redundant descriptions. In the present disclosure, the X1-X2 direction, the Y1-Y2 direction, and the Z1-Z2 direction are mutually orthogonal directions. A plane including the X1-X2 direction and the Y1-Y2 direction will be referred to as an XY plane, a plane including the Y1-Y2 direction and the Z1-Z2 direction will be referred to as a YZ plane, and a plane including the Z1-Z2 direction and the X1-X2 direction will be referred to as a ZX plane. For convenience, the Z1-Z2 direction is a vertical direction, the Z1 side is an upper side, and the Z2 side is a lower side. Further, "plan view" means that the object is viewed from the Z1 side, and "planar shape" means a shape of the object viewed from the Z1 side.

### (First embodiment)

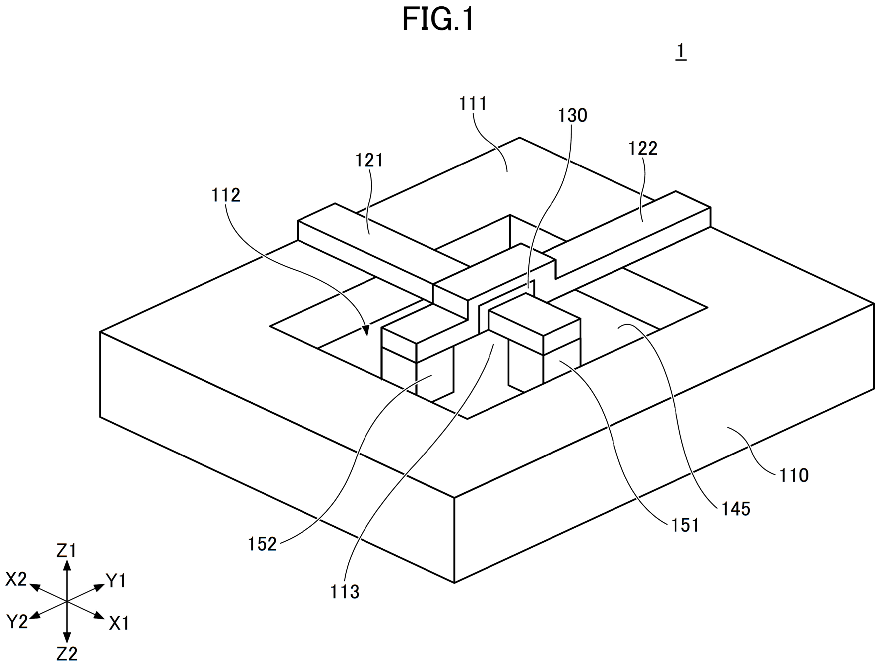

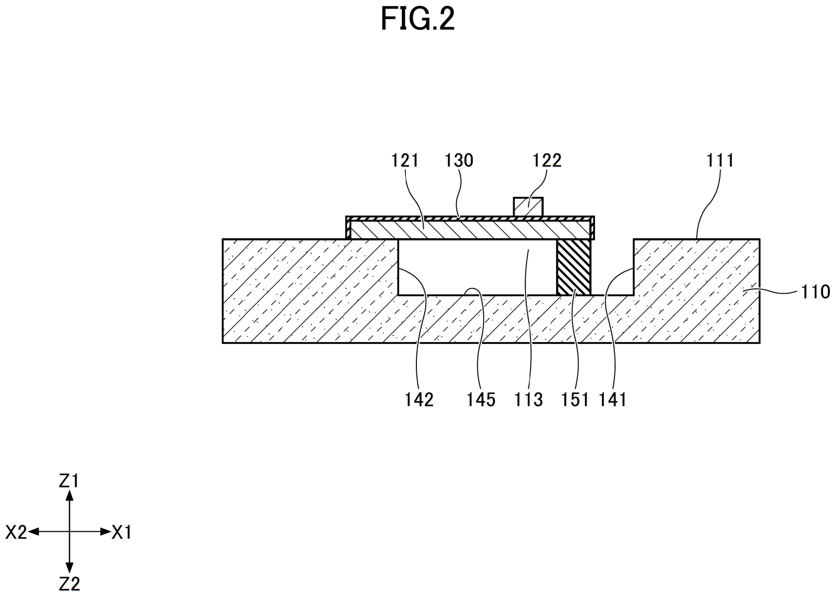

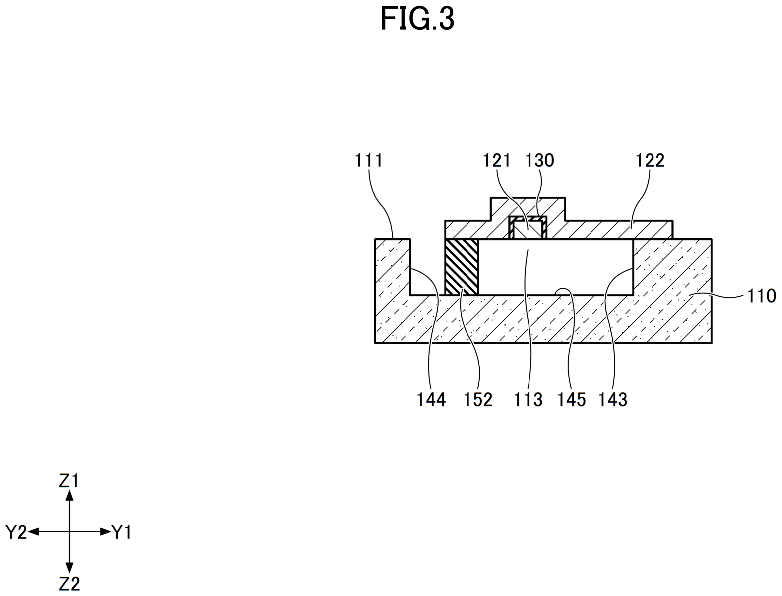

A first embodiment will be described. The first embodiment relates to an electronic device. FIG. 1 is a perspective view illustrating an electronic device according to the first embodiment. FIGS. 2 and 3 are cross-sectional views illustrating an electronic device according to the first embodiment.

As illustrated in FIGS. 1 to 3, an electronic device 1 according to the first embodiment includes a substrate 110, a superconducting wiring 121, a superconducting wiring 122, an insulating film 130, a support member 151, and a support member 152.

The substrate 110 is, for example, a silicon substrate or a sapphire substrate. A recessed portion 112 is formed on an upper surface 111 of the substrate 110. The upper surface 111 is a surface parallel to the XY plane. The recessed portion 112 has a rectangular planar shape having 2 sides parallel to the X1-X2 direction and 2 sides parallel to the Y1-Y2 direction. For example, the depth (dimension in the Z1-Z2 direction) of the recessed portion 112 is constant. The recessed portion 112 has sidewall surfaces 141 and 142 parallel to the YZ plane, sidewall surfaces 143 and 144 parallel to the ZX plane, and a bottom surface 145 parallel to the XY plane. The sidewall surface 141 is located on the X1 side of the sidewall surface 142, and the sidewall surface 143 is located on the Y1 side of the sidewall surface 144. The upper surface 111 is an example of the first surface.

The support members 151 and 152 are, for example, silicon oxide (SiO₂) films. The support members 151 and 152 are provided in the recessed portion 112. The height (thickness) of the support members 151 and 152 is preferably equal to the depth of the recessed portion 112, but may be greater than or less than the depth of the recessed portion 112. The support member 151 is arranged near the sidewall surface 141, and the support member 152 is arranged near the sidewall surface 144. The distance between the support member 151 and the sidewall surface 141 is shorter than the distance between the support member 151 and the sidewall surface 142, and the distance between the support member 151 and the sidewall surface 143 is longer than the distance between the support member 151 and the sidewall surface 144. The distance between the support member 152 and the sidewall surface 143 is longer than the distance between the support member 152 and the sidewall surface 144, and the distance between the support member 152 and the sidewall surface 141 is shorter than the distance between the support member 152 and the sidewall surface 142. The distance between the support member 151 and the sidewall surface 141 is shorter than the distance between the support member 152 and the sidewall surface 141, and the distance between the support member 152 and the sidewall surface 144 is shorter than the distance between the support member 151 and the sidewall surface 144. The support member 151 is an example of the first support member, and the support member 152 is an example of the second support member.

The superconducting wiring 121 and the superconducting wiring 122 are, for example, aluminum (Al) films. The superconducting wiring 121 extends along the X1-X2 direction. A portion of the superconducting wiring 121 is in contact with a portion of the upper surface 111 of the substrate 110 which is located on the X2 side of the sidewall surface 142. The superconducting wiring 121 is separated from the sidewall surfaces 141, 143, and 144 in a plan view and does not overlap the sidewall surfaces 141, 143, and 144. The X1 side end of the superconducting wiring 121 is supported by a support member 151. The superconducting wiring 122 extends along the Y1-Y2 direction. A portion of the superconducting wiring 122 is in contact with a portion of the upper surface 111 of the substrate 110 located on the Y1 side of the sidewall surface 143. The superconducting wiring 122 is separated from the sidewall surfaces 141, 142 and 144 and does not overlap the sidewall surfaces 141, 142 and 144 in a plan view. The Y2 side end of the superconducting wiring 122 is supported by a support member 152.

The superconducting wiring 121 and the superconducting wiring 122 intersect each other in a plan view. That is, a part of the superconducting wiring 121 between the support member 151 and the sidewall surface 142 and a part of the superconducting wiring 122 between the support member 152 and the sidewall surface 143 overlap each other in the Z1-Z2 direction in a plan view. The superconducting wiring 121 is an example of the first superconducting wiring, and the superconducting wiring 122 is an example of the second superconducting wiring.

The insulating film 130 is, for example, an aluminum oxide (Al₂O₃) film. The insulating film 130 is provided between the superconducting wiring 121 and the superconducting wiring 122. The insulating film 130 is provided between the superconducting wiring 121 and the superconducting wiring 122 in a region where the superconducting wiring 121 and the superconducting wiring 122 overlap each other. The insulating film 130 is in contact with the superconducting wiring 121 and the superconducting wiring 122. The insulating film 130 may cover other portions of the superconducting wiring 121. The thickness of the insulating film 130 is such that a tunnel effect can be generated between the superconducting wiring 121 and the superconducting wiring 122. Although the insulating film 130 covers the upper surface and the side surface of the superconducting wiring 121, FIG. 1 does not illustrate the insulating film except for the portion between the superconducting wiring 121 and the superconducting wiring 122.

In the electronic device 1, a region where the superconducting wiring 121 and the superconducting wiring 122 intersect in a plan view functions as a superconducting Josephson junction element in a cryogenic environment of approximately 10 mK, for example. Also, a space 113 exists between the region functioning as the superconducting Josephson junction element and the bottom surface 145 of the recessed portion 112. That is, a hollow portion is formed between the region functioning as the superconducting Josephson junction element and the bottom surface 145 of the recessed portion 112.

When the superconducting wiring 121 and the superconducting wiring 122 are formed directly on the upper surface of a substrate without forming the recessed portion 112, the region functioning as the superconducting Josephson junction element comes into direct contact with the substrate 110. When the substrate 110 is a silicon substrate, an oxide inevitably exists on the upper surface 111 due to natural oxidation. The oxide acts as a defect referred to as a two-level system (TLS) on the Josephson junction element, deprives the Josephson junction element of energy, and shortens the coherence time of a quantum bit having the Josephson junction element. When the coherence time is shortened, the time for maintaining the quantum entangled state is also shortened, and the time for allowing quantum computation in a quantum computer having the quantum bit is shortened, which lowers fidelity.

On the other hand, in the present embodiment, a hollow portion is formed between the region functioning as the superconducting Josephson junction element and the bottom surface 145 of the recessed portion 112. Therefore, even if oxide exists on the bottom surface 145, the influence of TLS can be reduced.

Further, because the superconducting wiring 121 is supported by the support member 151 and the superconducting wiring 122 is supported by the support member 152, the shapes of the superconducting wiring 121 and the superconducting wiring 122 are stable even above the recessed portion 112. Further, the relative permittivity of the material of the support member 151 and the support member 152, for example, silicon oxide, is lower than the relative permittivity of the material of the substrate 110, for example, silicon, and, therefore, the parasitic capacitance between the superconducting wiring 121 and the substrate 110 and the parasitic capacitance between the superconducting wiring 122 and the substrate 110 can be reduced to a low level. Further, even if the material of the support member 151 and the support member 152 is an oxide, because the support member 151 and the support member 152 are separated from the Josephson junction element, the influence of TLS existing on the support member 151 and the support member 152 does not appreciably affect the Josephson junction element.

Further, because the superconducting wiring 121 and the superconducting wiring 122 intersect each other in a plan view, the superconducting wiring 121 and the superconducting wiring 122 can be easily formed with high accuracy as described below.

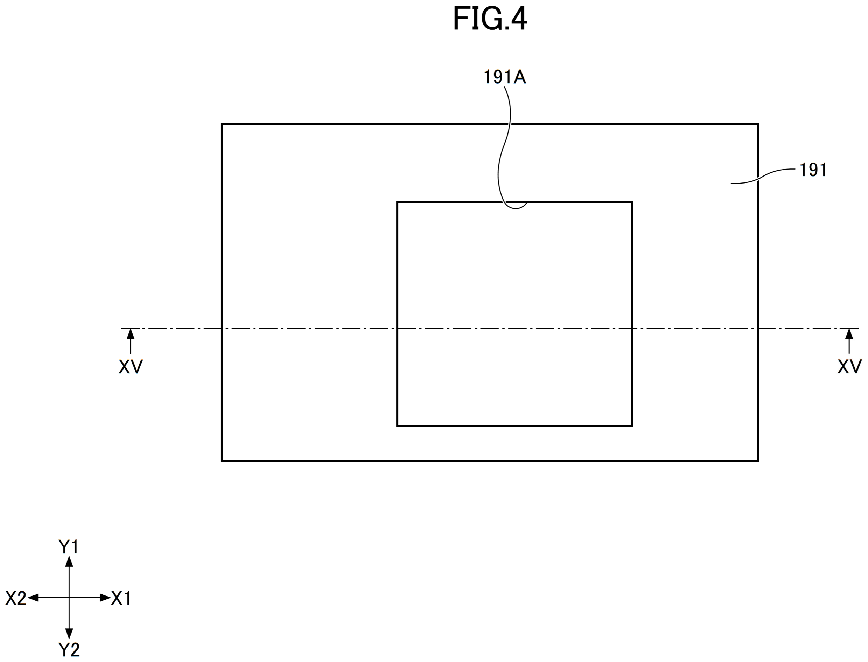

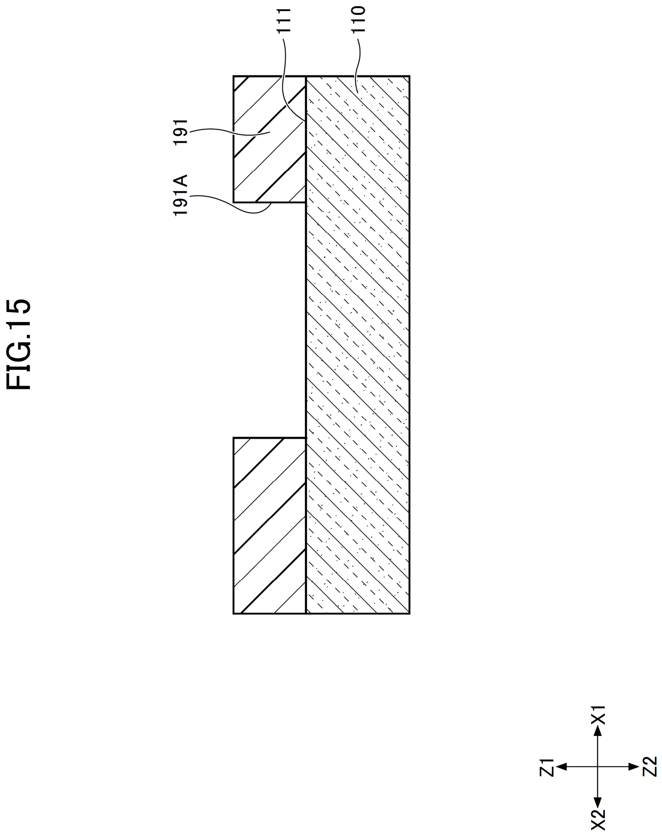

Next, a method of manufacturing an electronic device according to the first embodiment will be described. FIGS. 4 to 14 are plan views illustrating a method of manufacturing an electronic device according to the first embodiment, and FIGS. 15 to 25 are cross-sectional views illustrating a method of manufacturing an electronic device according to the first embodiment.

First, as illustrated in FIGS. 4 and 15, a substrate 110 is prepared, and a mask 191 is formed on the upper surface 111 of the substrate 110. The mask 191 has an opening 191A through which a region for forming the recessed portion 112 of the substrate 110 is exposed. The mask 191 is, for example, a resist mask. FIG. 15 corresponds to a cross-sectional view taken along a line XV-XV in FIG. 4.

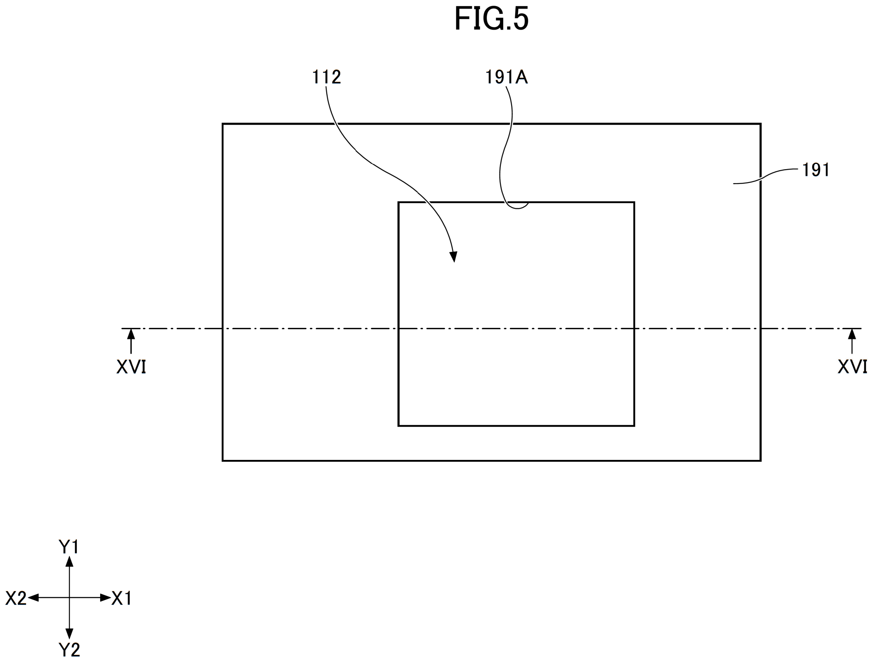

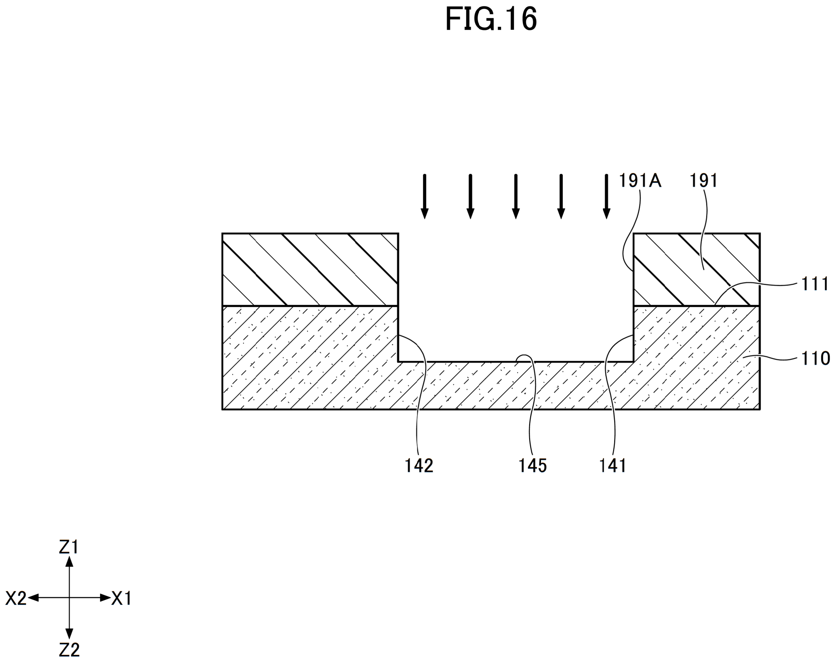

Next, as illustrated in FIGS. 5 and 16, a portion of the substrate 110 exposed from the opening 191A is etched to form a recessed portion 112 on the upper surface 111. The substrate 110 may be etched by either wet etching or dry etching. FIG. 16 corresponds to a cross-sectional view taken along a line XVI-XVI in FIG. 5.

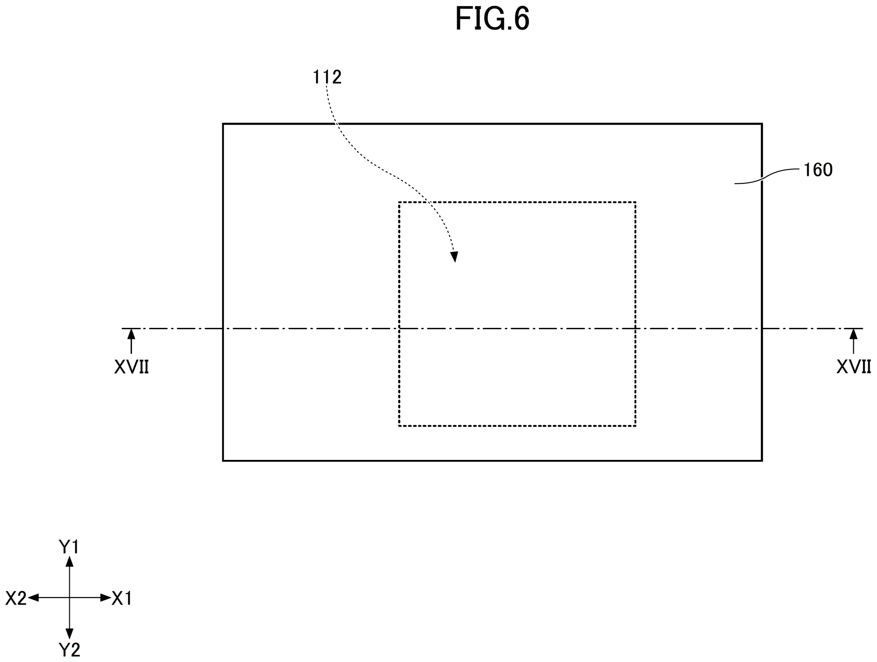

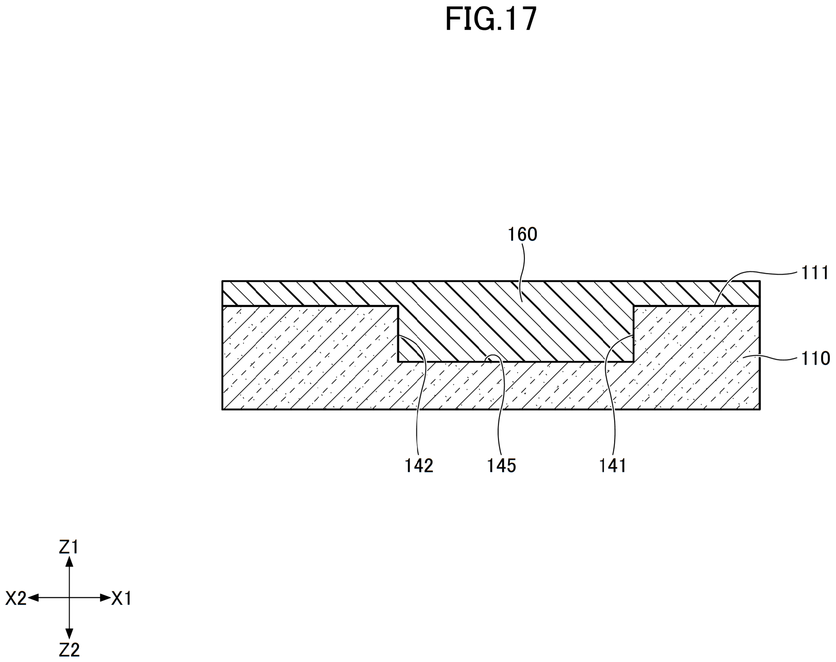

Then, as illustrated in FIGS. 6 and 17, the mask 191 is removed, and a resin layer 160 is formed on the substrate 110 so as to fill the inside of the recessed portion 112. The resin layer 160 is, for example, a polyimide layer. In forming the resin layer 160, for example, a polyimide resin is applied and thermally cured. FIG. 17 corresponds to a cross-sectional view taken along a line XVII-XVII in FIG. 6.

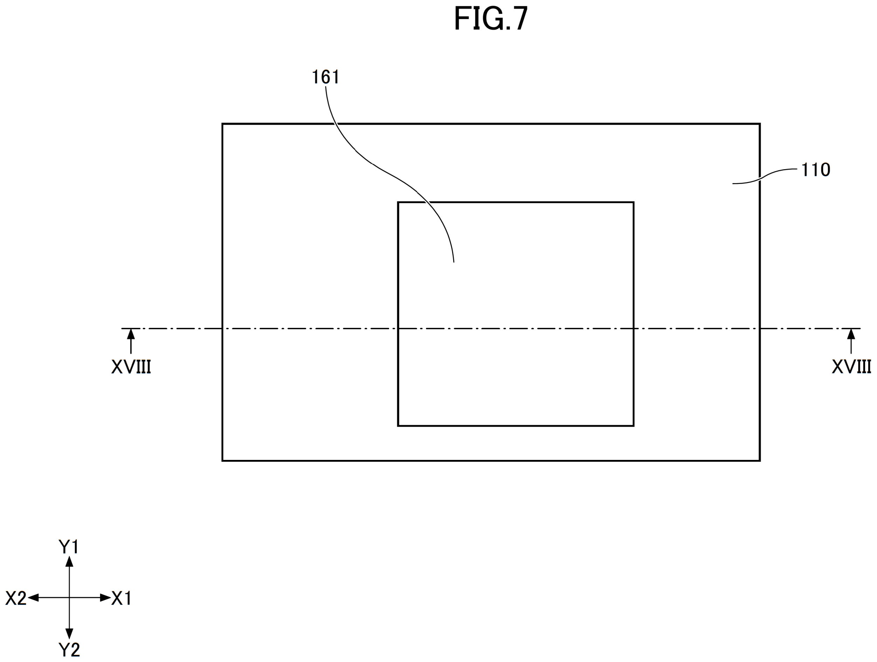

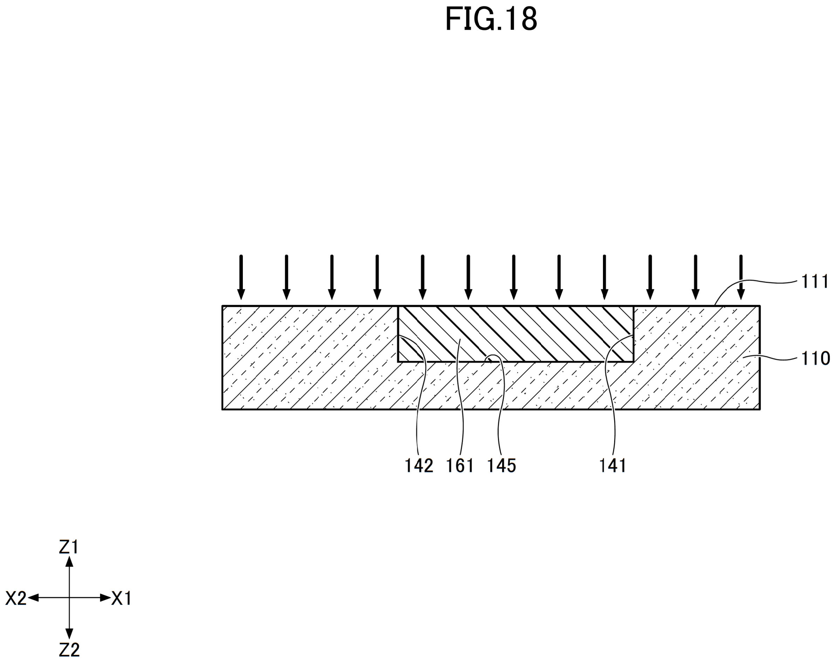

Subsequently, as illustrated in FIGS. 7 and 18, the resin layer 160 is etched back so that the resin layer 160 remains in the recessed portion 112. As a result, an embedded member 161 composed of the resin layer 160 is formed in the recessed portion 112. In the etching back of the resin layer 160, dry etching is performed by using, for example, oxygen (O₂). FIG. 18 corresponds to a cross-sectional view taken along a line XVIII-XVIII in FIG. 7.

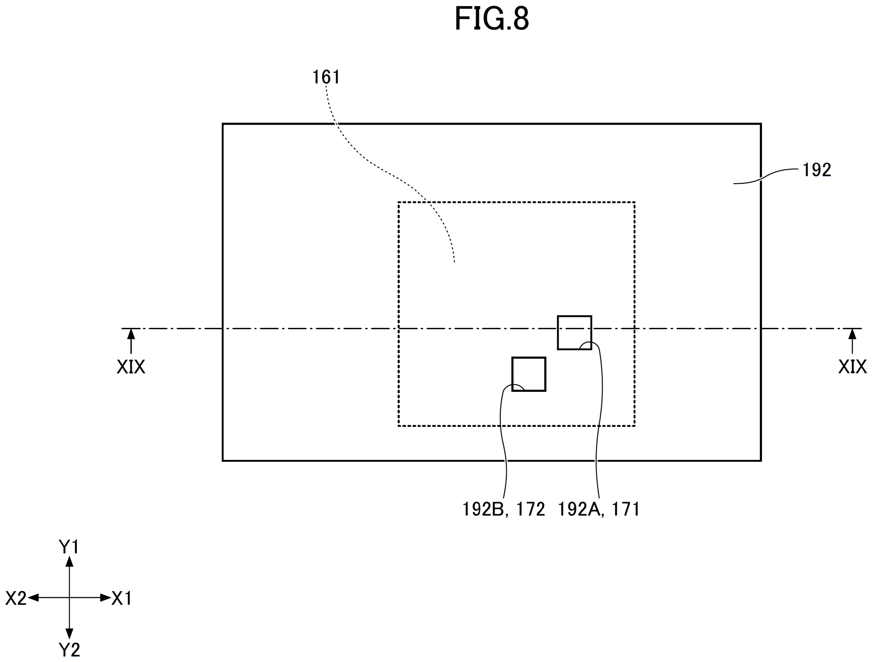

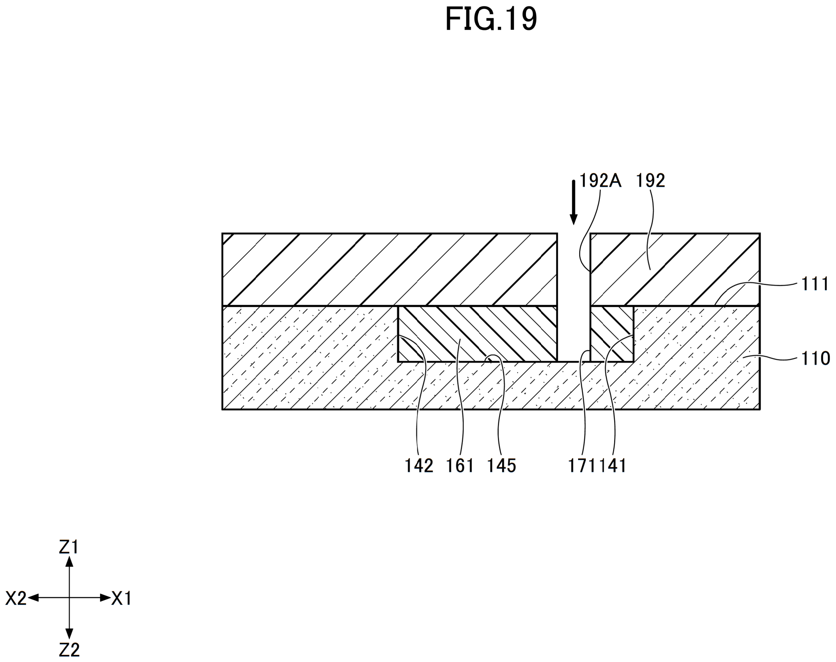

Next, as illustrated in FIGS. 8 and 19, a mask 192 is formed on the substrate 110 and the embedded member 161. The mask 192 has an opening 192A where a region for forming the support member 151 is exposed, and an opening 192B where a region for forming the support member 152 is exposed. The mask 192 is, for example, a resist mask. Then, a portion exposed from the opening 192A and a portion exposed from the opening 192B of the embedded member 161 are etched to form an opening 171 and an opening 172 in the embedded member 161. The opening 171 is connected to the opening 192A, and the opening 172 is connected to the opening 192B. The embedding member 161 is etched, for example, by dry etching. FIG. 19 corresponds to a cross-sectional view taken along the XIX-XIX line in FIG. 8.

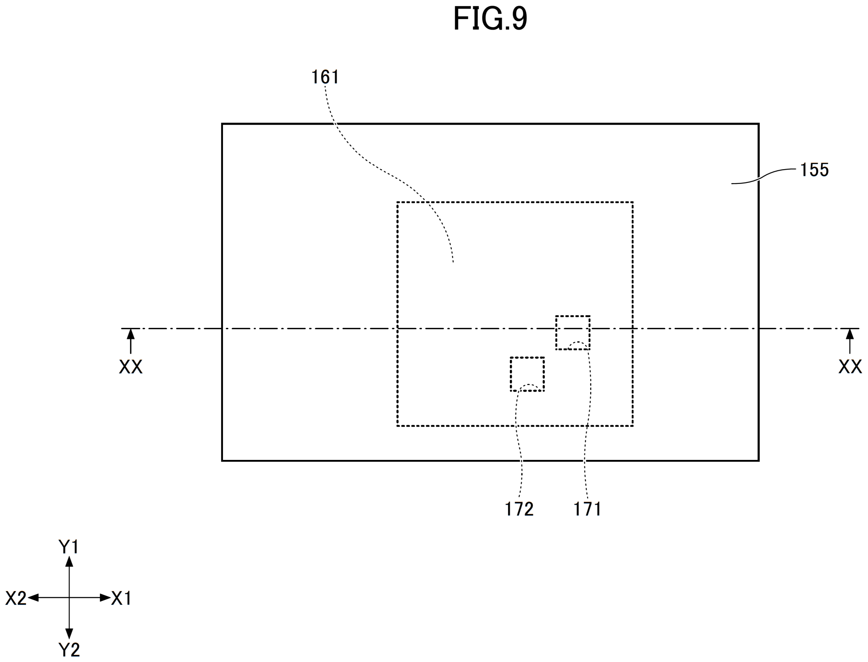

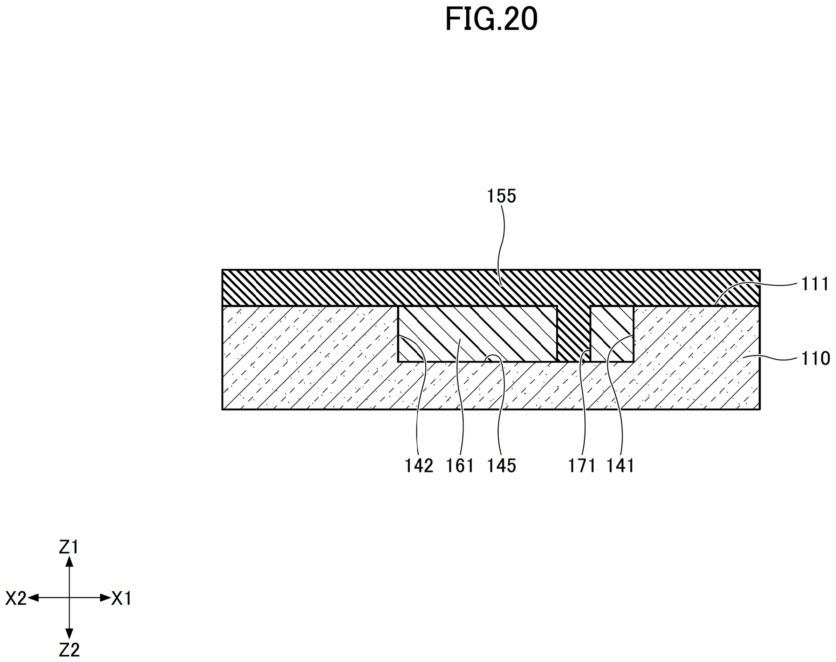

Subsequently, as illustrated in FIGS. 9 and 20, the mask 192 is removed, and films 155 of the material of the support member 151 and the support member 152 are formed on the substrate 110 and the embedding member 161 so as to fill the inside of the opening 171 and the inside of the opening 172. The film 155 is, for example, an SiO₂ film. The film 155 can be formed by, for example, sputtering or spin-on-glass (SOG) coating and curing. FIG. 20 corresponds to a cross-sectional view taken along the XX-XX line in FIG. 9.

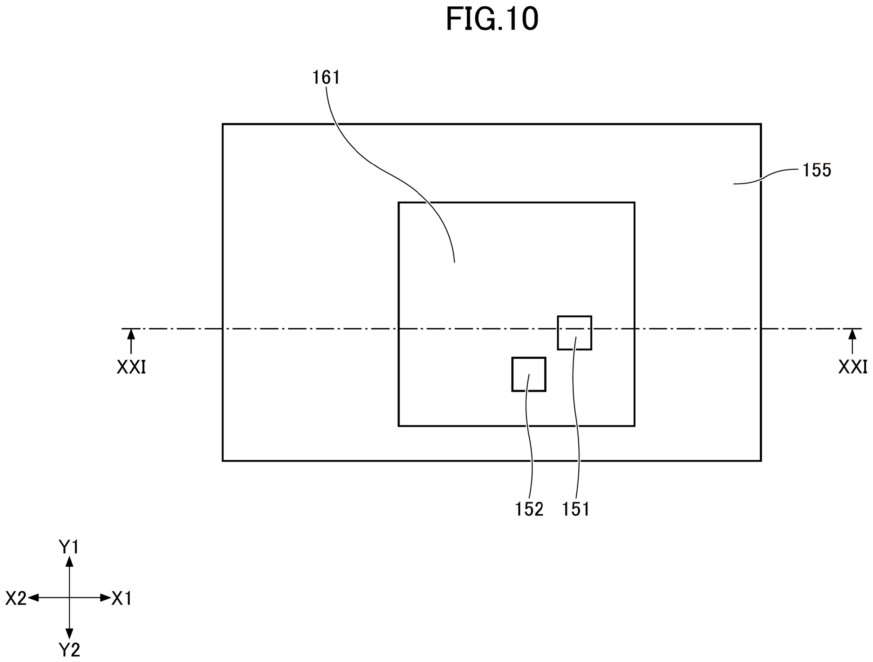

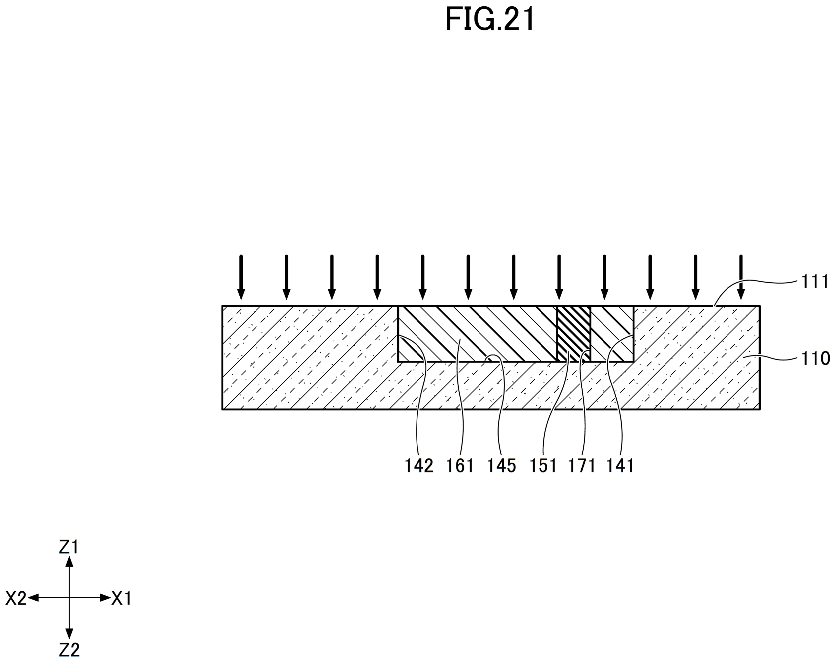

Next, as illustrated in FIGS. 10 and 21, the film 155 is etched back so that the film 155 remains in the openings 171 and 172. As a result, a support member 151 composed of the film 155 is formed in the opening 171, and a support member 152 is formed in the opening 172. In etching back of the film 155, dry etching is performed by using, for example, methane tetrafluoride (CF₄). FIG. 21 corresponds to a cross-sectional view taken along a line XXI-XXI in FIG. 10.

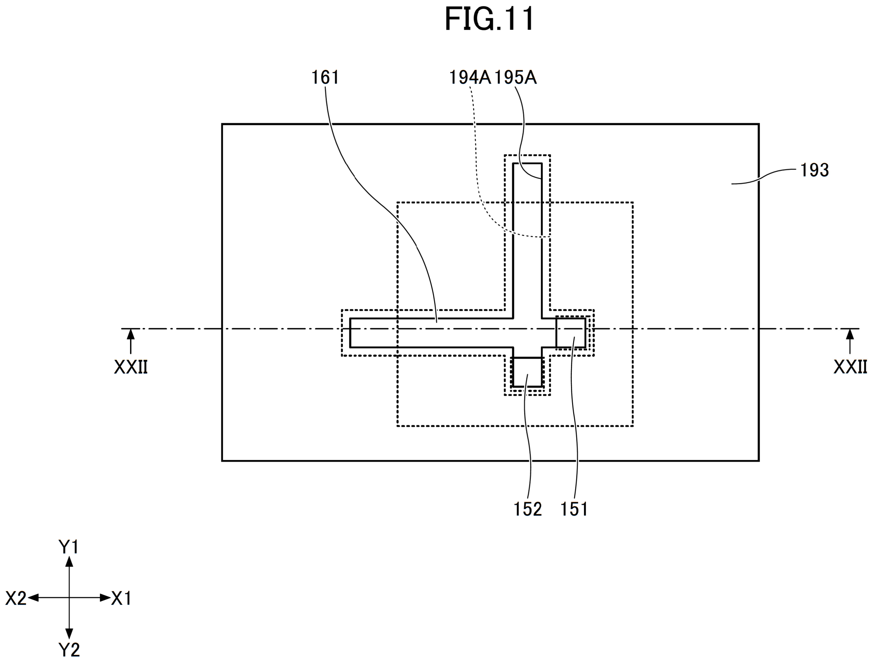

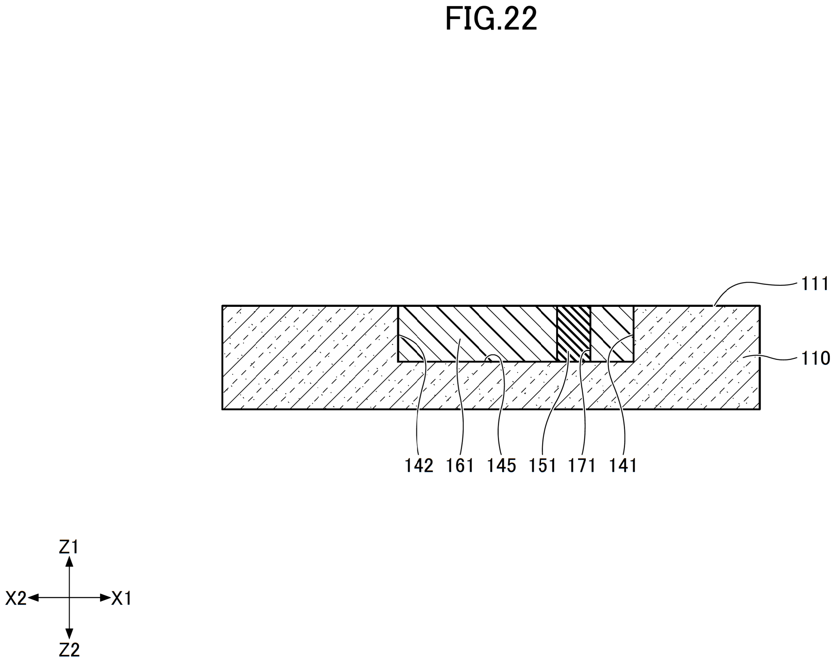

Thereafter, as illustrated in FIGS. 11 and 22, a mask 193 is formed on the substrate 110 and the embedded member 161. The mask 193 has a 2-layer structure and includes a lower layer 194 and an upper layer 195. The lower layer 194 is formed on the substrate 110 and the embedded member 161, and the upper layer 195 is formed on the lower layer 194. The upper layer 195 includes an opening 195A exposing a region for forming the superconducting wiring 121 and the superconducting wiring 122. The opening 195A has a cross-shaped planar shape. The lower layer 194 includes an opening 194A wider than the opening 195A. The opening 194A also has a cross-shaped planar shape. FIG. 22 corresponds to a cross-sectional view taken along a line XXII-XXII in FIG. 11.

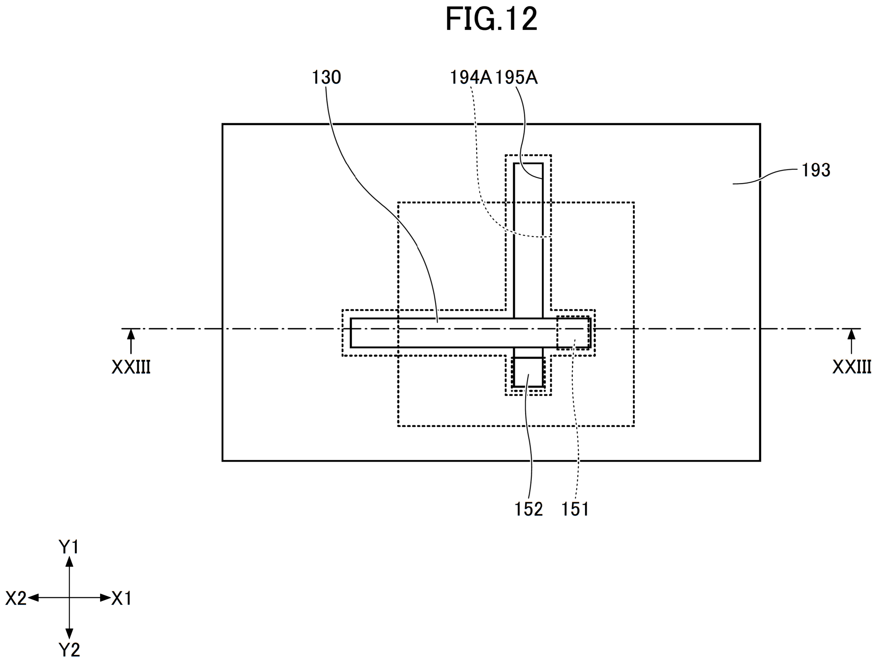

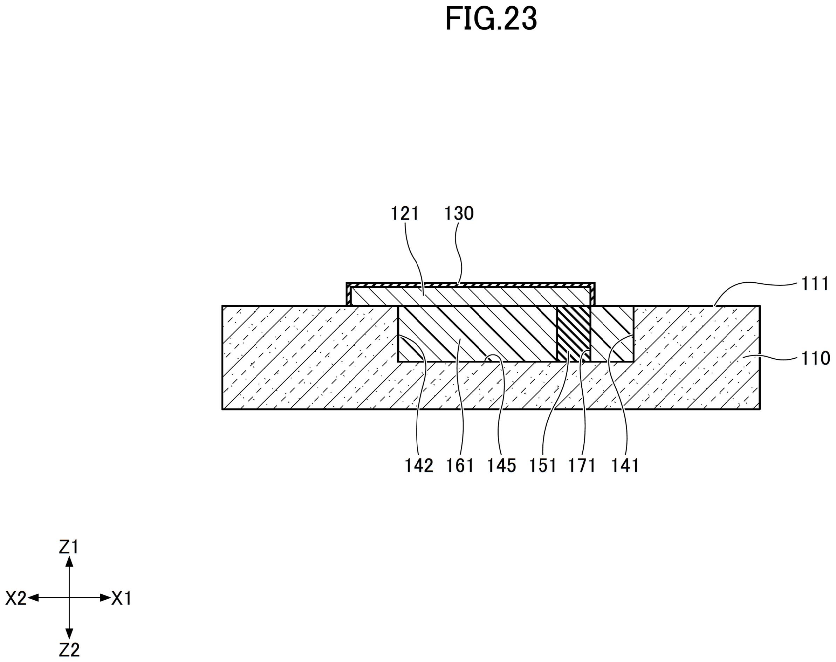

Subsequently, as illustrated in FIGS. 12 and 23, aluminum is evaporated in a direction inclined from the Z1 side to the X1 side when viewed from the upper surface 111, thereby forming an aluminum film on the support member 151, the embedded member 161, and the substrate 110. Next, the surface of the aluminum film is oxidized. As a result, the superconducting wiring 121 and the insulating film 130 are formed from the aluminum film. FIG. 23 corresponds to a cross-sectional view taken along a line XXIII-XXIII in FIG. 12.

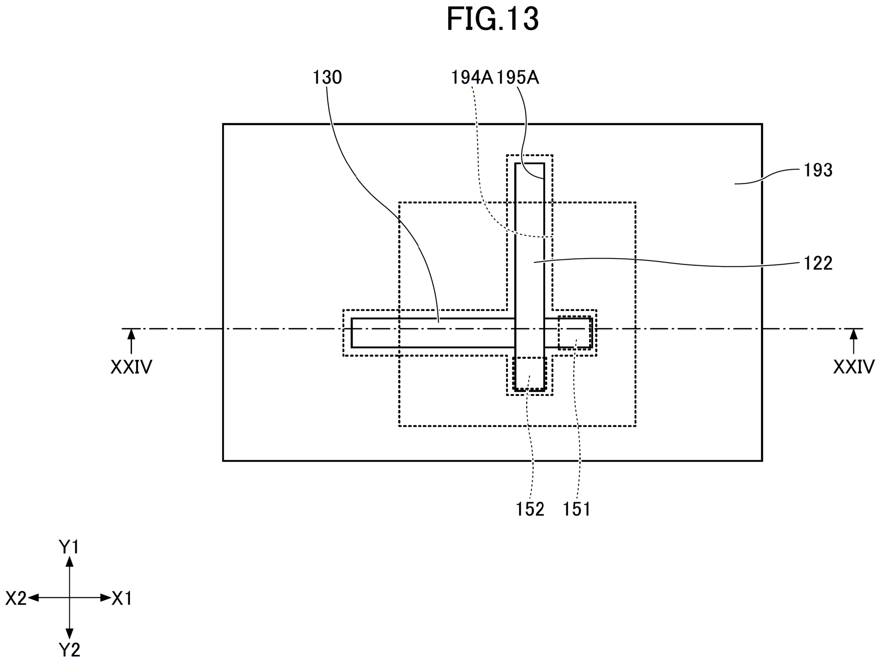

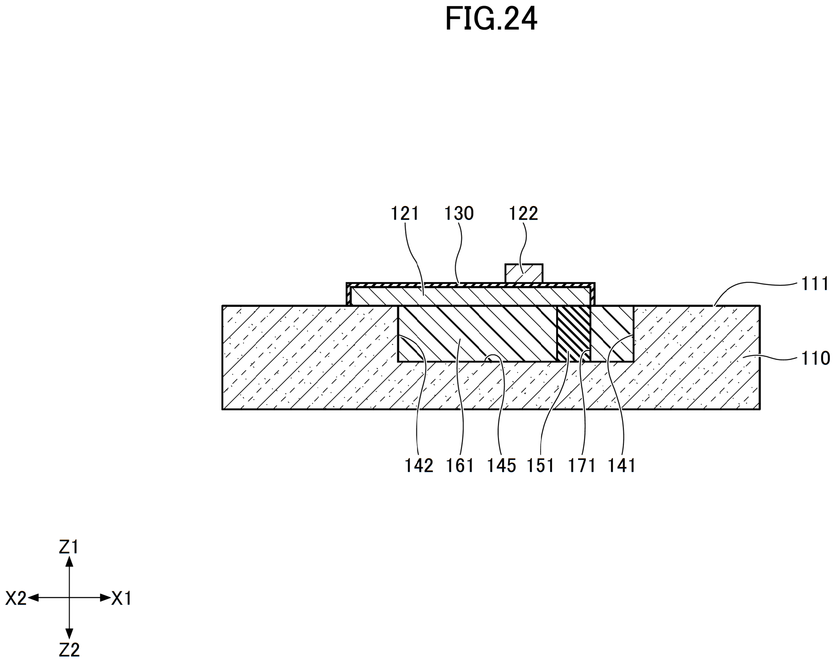

Thereafter, as illustrated in FIGS. 13 and 24, aluminum is evaporated in a direction inclined from the Z1 side to the Y2 side as seen from the upper surface 111, thereby forming the superconducting wiring 122 on the support member 152, the embedded member 161, the insulating film 130, and the substrate 110. FIG. 24 corresponds to a cross-sectional view taken along a line XXIV-XXIV in FIG. 13.

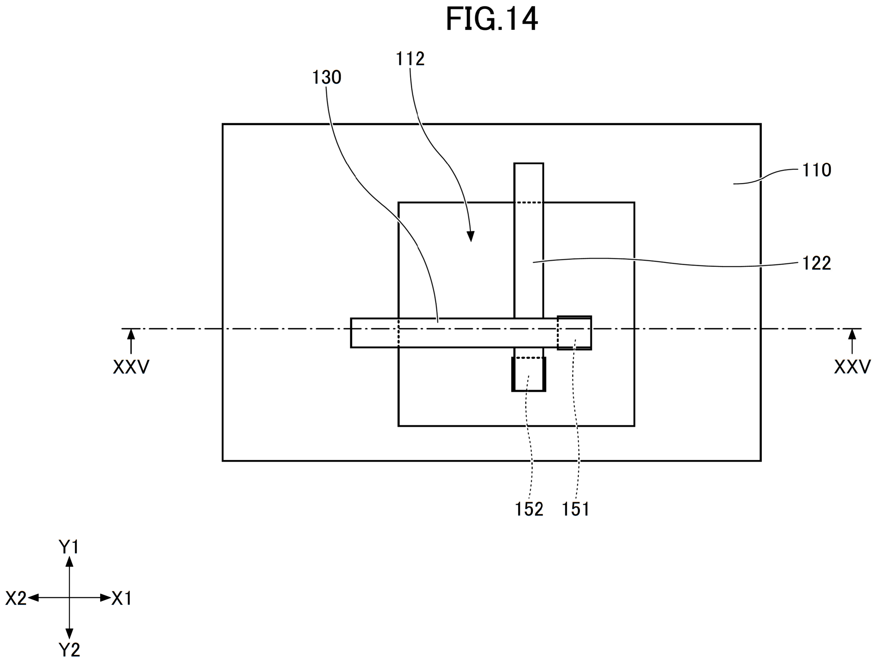

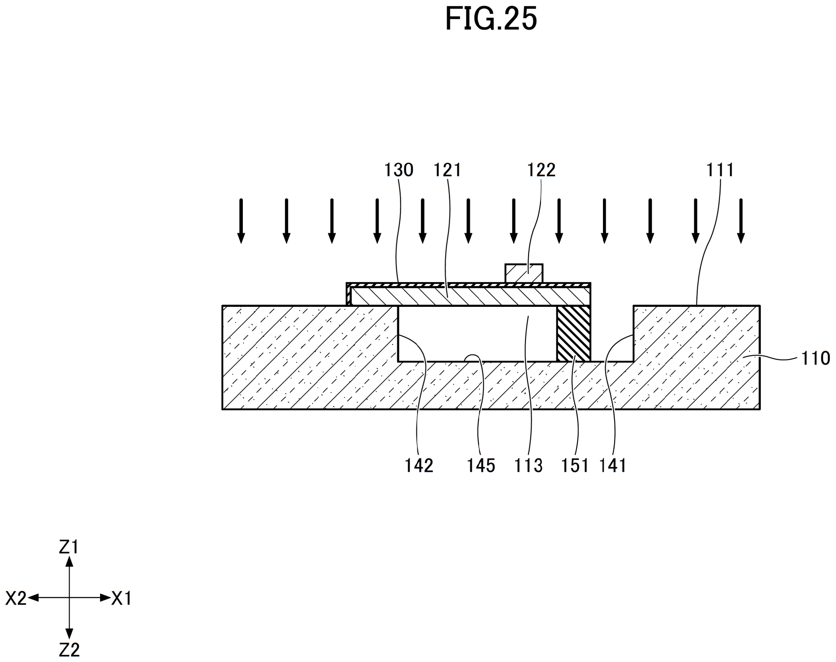

Subsequently, as illustrated in FIGS. 14 and 25, the mask 193 is removed by, for example, a lift-off method. Then, the embedded member 161 is removed. In removing the embedded member 161, dry etching is performed by using, for example, oxygen (O₂). At this time, by increasing the gas pressure, the embedded member 161 below the superconducting wiring 121 and the superconducting wiring 122 can be easily removed. FIG. 25 corresponds to a cross-sectional view taken along a line XXV-XXV in FIG. 14.

According to such a manufacturing method, because a lift-off method is used, the support member 151, the support member 152, the superconducting wiring 121, and the superconducting wiring 122 can be formed with high accuracy.

### (Second embodiment)

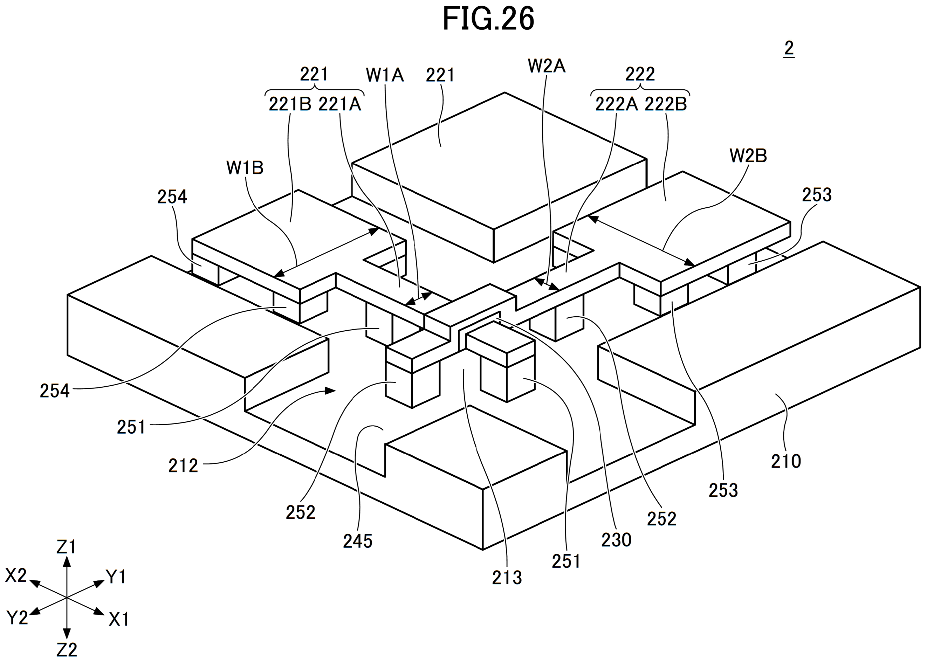

Next, a second embodiment will be described. The second embodiment differs from the first embodiment mainly in the structure of the superconducting wiring and the arrangement of the support members. The second embodiment relates to an electronic device. FIG. 26 is a perspective view illustrating an electronic device according to the second embodiment.

As illustrated in FIG. 26, the electronic device 2 according to the second embodiment includes a substrate 210, a superconducting wiring 221, a superconducting wiring 222, an insulating film 230, two support members 251, two support members 252, four support members 253, and four support members 254. Although the present embodiment discloses a structure having two support members 251, two support members 252, four support members 253, and four support members 254, the number of support members is not limited to this.

The substrate 210 is, for example, a silicon substrate or a sapphire substrate. A recessed portion 212 is formed in an upper surface 211 of the substrate 210. The upper surface 211 is a surface parallel to the XY plane. The recessed portion 212 has a cross-shaped planar shape. For example, the depth (dimension in the Z1-Z2 direction) of the recessed portion 212 is constant. The upper surface 211 is an example of the first surface.

The support members 251, 252, 253, and 254 are, for example, SiO₂ films. The support members 251, 252, 253 and 254 are provided in the recessed portion 212. The height (thickness) of the support members 251, 252, 253 and 254 is preferably equal to the depth of the recessed portion 212, but may be larger or smaller than the depth of the recessed portion 212.

The two support members 251 are arranged side by side in the X1-X2 direction at a portion of the recessed portion 212 extending parallel to the X1-X2 direction. The four support members 253 are arranged on the X2 side of the two support members 251 and are arranged in a square lattice shape parallel to the X1-X2 direction and the Y1-Y2 direction.

The two support members 252 are arranged side by side in the Y1-Y2 direction at a portion of the recessed portion 212 extending in parallel to the Y1-Y2 direction. The four support members 254 are arranged on the Y1 side of the two support members 252 and are arranged in a square lattice shape parallel to the X1-X2 direction and the Y1-Y2 direction.

The superconducting wiring 221 and the superconducting wiring 222 are, for example, an Al film. The superconducting wiring 221 extends along the X1-X2 direction. The superconducting wiring 221 has a thin wire portion 221A having a width W1A in the Y1-Y2 direction and a thick wire portion 221B having a width W1B in the Y1-Y2 direction. The width W1B is wider than the width W1A. The thin wire portion 221A and the thick wire portion 221B are connected to each other. The thin wire portion 221A is supported by two support members 251, and the thick wire portion 221B is supported by four support members 253. The superconducting wiring 222 extends along the Y1-Y2 direction. The superconducting wiring 222 has a thin wire portion 222A having a width W2A in the X1-X2 direction, and a thick wire portion 222B having a width W2B in the X1-X2 direction. The width W2B is wider than the width W2A. The thin wire portion 222A and the thick wire portion 222B are connected to each other. The thin wire portion 222A is supported by two support members 252, and the thick wire portion 222B is supported by four support members 254. The thin wire portions 221A and 222A are examples of the first portion, and the thick wire portions 221B and 222B are examples of the second portion.

In a plan view, the thin wire portion 221A of the superconducting wiring 221 and the thin wire portion 222A of the superconducting wiring 222 intersect each other. In a plan view, a part of the thin wire portion 221A between the two support members 251 and a part of the thin wire portion 222A between the two support members 252 overlap in the Z1-Z2 direction. The superconducting wiring 221 is an example of the first superconducting wiring, and the superconducting wiring 222 is an example of the second superconducting wiring.

The insulating film 230 is, for example, an Al₂O₃ film. The insulating film 230 is provided between the thin wire portion 221A and the thin wire portion 222A. The insulating film 230 is provided between the thin wire portion 221A and the thin wire portion 222A in a region where the thin wire portion 221A and the thin wire portion 222A overlap each other. The insulating film 230 is in contact with the thin wire portion 221A and the thin wire portion 222A. The insulating film 230 may cover other portions of the superconducting wiring 221. The thickness of the insulating film 230 is such that a tunnel effect can occur between the thin wire portion 221A and the thin wire portion 222A. Although the insulating film 230 covers the upper surface and the side surface of the superconducting wiring 221, FIG. 26 does not illustrate the insulating film except for a portion between the superconducting wiring 121 and the superconducting wiring 122.

In the electronic device 2, a region where the thin wire portion 221A and the thin wire portion 222A intersect in a plan view functions as a superconducting Josephson junction element in a cryogenic environment of approximately 10 mK, for example. A space 213 exists between the region functioning as the superconducting Josephson junction element and the bottom surface 245 of the recessed portion 212. That is, a hollow portion is formed between the region functioning as the superconducting Josephson junction element and the bottom surface 245 of the recessed portion 212. Therefore, even if an oxide exists at the bottom surface 245, the influence of TLS can be reduced.

Further, in the electronic device 2, a hollow portion is formed not only between the region functioning as the superconducting Josephson junction element and the bottom surface 245 of the recessed portion 212, but also between the thick wire portion 221B and the bottom surface 245, and between the thick wire portion 222B and the bottom surface 245. Therefore, the parasitic capacitance between the superconducting wiring 221 and the substrate 210 and the parasitic capacitance between the superconducting wiring 222 and the substrate 210 can be further reduced. The thick wire portion 221B and the thick wire portion 222B are used for electrical connection or the like between other elements.

The electronic device 2 according to the second embodiment can be manufactured by a method according to the first embodiment. For example, the electronic device 2 according to the second embodiment can be manufactured by changing the pattern of the mask used for etching from that of the first embodiment.

Although not illustrated, the thick wire portion 221B may be in contact with the upper surface 211 of the substrate 210, and the thick wire portion 222B may be in contact with the upper surface 211 of the substrate 210.

### (Third embodiment)

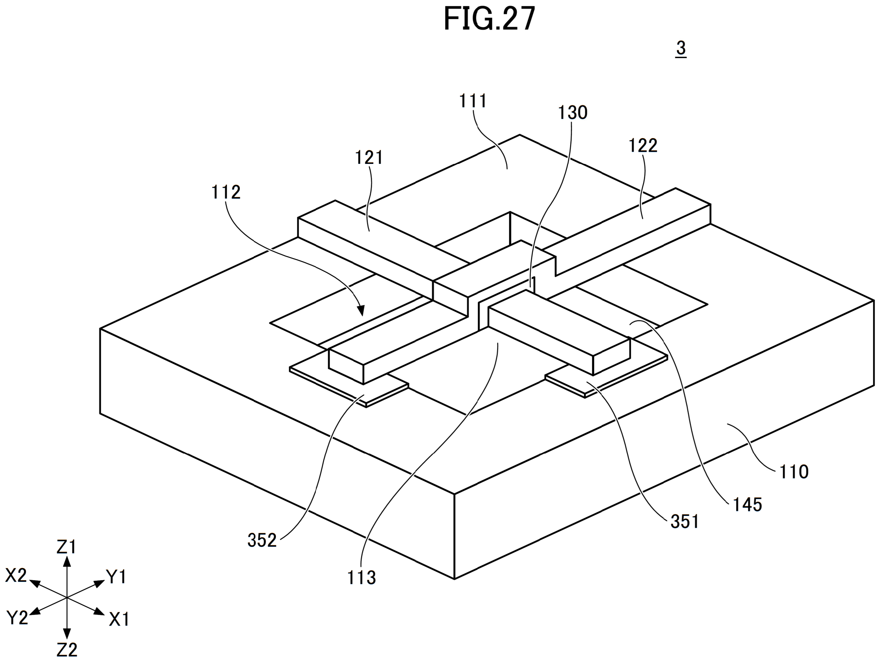

Next, the third embodiment will be described. The third embodiment differs from the first embodiment mainly in the arrangement of the support members. FIG. 27 is a perspective view illustrating an electronic device according to the third embodiment.

As illustrated in FIG. 27, the electronic device 3 according to the third embodiment has a support member 351 instead of the support member 151 and a support member 352 instead of the support member 152.

The support members 351 and 352 are, for example, SiO₂ films. The thickness of the support members 351 and 352 is approximately 100 nm. The support members 351 and 352 are provided on the upper surface 111 of the substrate 110. The support member 351 is provided on a portion of the upper surface 111 of the substrate 110 on the X1 side of the sidewall surface 141. The support member 352 is provided on a portion of the upper surface 111 of the substrate 110 on the Y2 side of the sidewall surface 144. The X1 side end of the superconducting wiring 121 is supported by the support member 351. The Y2 side end of the superconducting wiring 122 is supported by the support member 352.

Other configurations are the same as those of the first embodiment.

Also in the third embodiment, because a hollow portion is formed between the region functioning as the superconducting Josephson junction element and the bottom surface 145 of the recessed portion 112, the influence of TLS can be reduced even if an oxide exists on the bottom surface 145.

In the present disclosure, the relative permittivity of the support member is preferably lower than the relative permittivity of the substrate from the viewpoint of reducing parasitic capacitance, but the material of the support member is not limited to silicon oxide. For example, the support member may include silicon oxide, silicon nitride, aluminum oxide, or a resin. Examples of the resin include benzocyclobutene (BCB). The material of the superconducting wiring is also not limited to aluminum. For example, the superconducting wiring may include a superconducting material other than Al, such as niobium (Nb), niobium nitride (NbN), tantalum (Ta), tantalum nitride (TaN), or titanium nitride (TiN). The material of the insulating film sandwiched between the two superconducting wirings is not limited to aluminum oxide.

### (Fourth embodiment)

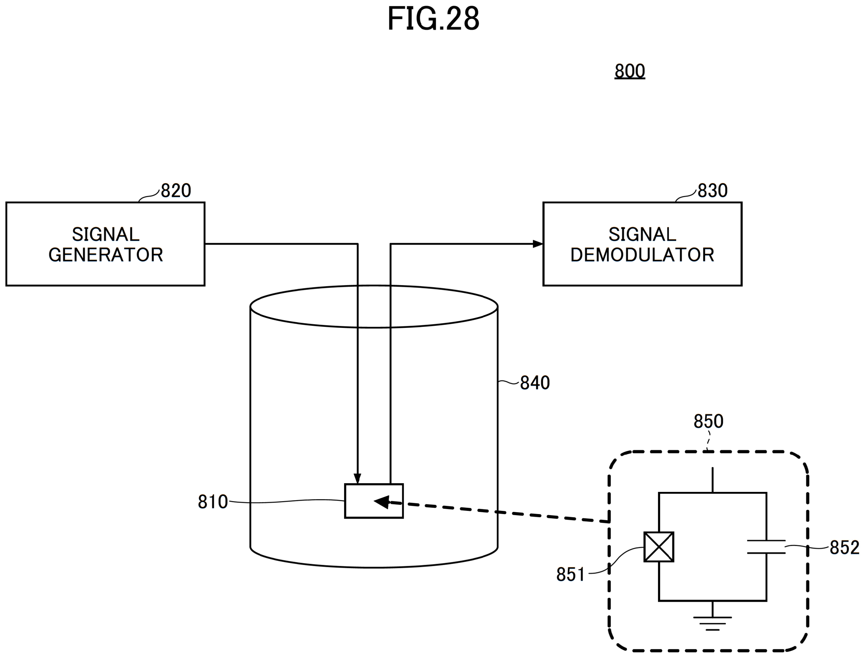

Next, a fourth embodiment will be described. The fourth embodiment relates to a quantum computing device including a Josephson junction element. FIG. 28 is a diagram illustrating a quantum computing device according to a fourth embodiment.

As illustrated in FIG. 28, a quantum computing device 800 according to a fourth embodiment, as illustrated in FIG. 30, includes a quantum bit chip 810, a signal generator 820, a signal demodulator 830, and a cryogenic dilution refrigerator 840. The quantum bit chip 810 is housed in the cryogenic dilution refrigerator 840 and is cooled to a temperature of 10 mK or less. The signal generator 820 generates a microwave pulse signal, and the microwave pulse signal is input to the quantum bit chip 810. The quantum bit chip 810 outputs a signal corresponding to the microwave pulse signal, and the signal demodulator 830 demodulates the signal output from the quantum bit chip 810. The signal generator 820 and the signal demodulator 830 are used at a temperature of approximately room temperature, for example.

The quantum bit chip 810 includes a plurality of superconducting quantum bits (transmons) 850, and each superconducting quantum bit 850 has a Josephson junction element 851 and a capacitor 852 electrically connected in parallel to the Josephson junction element 851. The Josephson junction element 851 is an electronic device according to any of the first to third embodiments, wherein one superconducting wiring and the other superconducting wiring are connected to the capacitor 852.

Because the Josephson junction element 851 included in the quantum computing device 800 according to the fourth embodiment is an electronic device according to any of the first to third embodiments, it is possible to obtain a long coherence time for the superconducting quantum bit 850, reduce errors in quantum computation, and improve fidelity.

The electronic device according to the present disclosure can be used for quantum computing, for example.

Although the preferred embodiments and the like have been described in detail, the present invention is not limited to the above-described embodiments and the like, and various modifications and substitutions can be made to the above-described embodiments and the like without departing from the scope of the claims.

### REFERENCE SIGNS LIST

1, 2, 3: electronic device
110, 210: substrate
111, 211: upper surface
112, 212: recessed portion
113, 213: space
121, 122, 221, 222: superconducting wiring
130, 230: insulating film
145, 245: bottom surface
151, 152, 251, 252, 253, 254, 351, 352: support member
160: resin layer
161: embedded member
221A, 222A: thin wire portion
221B, 222B: thick wire portion

## Claims

1. An electronic device comprising:
a substrate having a recessed portion in a first surface;
a first superconducting wiring having a portion in contact with the first surface;
a second superconducting wiring intersecting the first superconducting wiring in a plan view above the recessed portion and having a portion in contact with the first surface;
an insulating film provided between the first superconducting wiring and the second superconducting wiring; and
a first support member provided in the recessed portion and supporting at least one of the first superconducting wiring or the second superconducting wiring, wherein
a hollow portion is formed between a region where the first superconducting wiring and the second superconducting wiring intersect in a plan view and a bottom surface of the recessed portion.

2. The electronic device according to claim 1, wherein a relative permittivity of the first support member is lower than a relative permittivity of the substrate.

3. The electronic device according to claim 1 or 2, wherein
the first superconducting wiring is supported by the first support member,
the second superconducting wiring is supported by a second support member, and
the second support member is provided in the recessed portion.

4. The electronic device according to claim 3, wherein
each of the first superconducting wiring and the second superconducting wiring includes:
a first portion, and
a second portion having a width that is wider than that of the first portion in a plan view,
the first portion of the first superconducting wiring is supported by the first support member, the second portion of the first superconducting wiring is supported by a third support member, the first portion of the second superconducting wiring is supported by the second support member, and the second portion of the second superconducting wiring is supported by a fourth support member, and
the first portion of the first superconducting wiring and the first portion of the second superconducting wiring intersect in a plan view.

5. The electronic device according to claim 1 or 2, wherein the first support member supports at least one end of the first superconducting wiring or the second superconducting wiring.

6. The electronic device according to claim 1 or 2, wherein the first support member includes silicon oxide, silicon nitride, aluminum oxide, or a resin.

7. The electronic device according to claim 1 or 2, wherein the substrate is a silicon substrate or a sapphire substrate.

8. The electronic device according to claim 1 or 2, wherein the first superconducting wiring and the second superconducting wiring are aluminum wiring.

9. A method of manufacturing an electronic device, the method comprising:
forming a recessed portion in a first surface of a substrate;
forming an embedded member in the recessed portion;
forming an opening in the embedded member;
forming a support member in the opening;
forming a first superconductive wiring on the first surface and the embedded member;
forming an insulating film on the first superconducting wiring;
forming a second superconducting wiring that intersects the first superconducting wiring in a plan view, on the first surface, the embedded member, and the insulating film;
removing the embedded member from a portion between a region where the first superconducting wiring and the second superconducting wiring intersect in a plan view and a bottom surface of the recessed portion; and
forming at least one of the first superconducting wiring or the second superconducting wiring on the support member.

10. The method of manufacturing the electronic device according to claim 9, wherein a relative permittivity of the support member is lower than a relative permittivity of the substrate.

11. The method of manufacturing the electronic device according to claim 9 or 10, wherein the embedded member is a resin.
